Europäisches Patentamt

European Patent Office

Office européen des brevets

(11) Veröffentlichungsnummer: **0 506 217 A2**

(12) **EUROPÄISCHE PATENTANMELDUNG**

(21) Anmeldenummer: **92250066.5**

(22) Anmeldetag: **20.03.92**

(51) Int. Cl.5: **H01L 21/66**

(30) Priorität: **27.03.91 DE 4110441**

(43) Veröffentlichungstag der Anmeldung:
**30.09.92 Patentblatt 92/40**

(84) Benannte Vertragsstaaten:
**CH DE DK GB IT LI**

(71) Anmelder: **Schneider, Klaus**
**Ritterstrasse 11**
**W-1000 Berlin 61(DE)**

(72) Erfinder: **Schneider, Klaus**
**Ritterstrasse 11**
**W-1000 Berlin 61(DE)**

(74) Vertreter: **Pfenning, Meinig & Partner**
**Kurfürstendamm 170**
**W-1000 Berlin 15(DE)**

(54) **Verfahren zur Messung des gegenseitigen Versatzes der Lagen einer Multilayer-Anordnung und Vorrichtung zur Durchführung dieses Verfahrens.**

(57) Es wird ein Verfahren zur Messung des gegenseitigen Versatzes der mit Leiterbahnen versehenen Lagen einer Multilayer-Anordnung beschrieben. Die Kenntnis des Versatzes ermöglicht es, jeweils eine geeignete Position für die nachfolgend herzustellenden, zur elektrischen Verbindung der Leiterbahnebenen dienenden Bohrungen durch die Multilayer-Anordnung festzulegen. Hierzu trägt jede Lage in definierter Position ein optisch erkennbares Muster, wobei sich diese Muster in der Multilayer-Anordnung zumindest teilweise überdecken. In der Multilayer-Anordnung wird mindestens eine Inspektionsbohrung hergestellt, die die Muster jeder Lage schneidet. Die Schnittkanten jedes Musters werden in der Inspektionsbohrung optisch erfaßt und ihre Position wird zur Ermittlung des gegenseitigen Versatzes der Lagen herangezogen.

EP 0 506 217 A2

Die Erfindung betrifft ein Verfahren nach dem Oberbegriff des Anspruchs 1.

Die Leiterbahnen der einzelnen Lagen einer Multilayer-Anordnung werden nach dem Verpressen in der Weise elektrisch miteinander verbunden, daß an den Verbindungsstellen Löcher gebohrt werden, die dann mit einer metallischen Auskleidung versehen werden. Dieses Verfahren erfordert jedoch eine ausreichende Deckung der zu verbindenden Leiterbahnen zueinander im Bereich der Verbindungsstellen. Ist dies nicht der Fall, beispielsweise durch die Addition von Toleranzen, dann kann eine beabsichtigte Verbindung nicht zustande kommen oder sie ist so schwach, daß es schon nach relativ kurzer Betriebszeit zu einem Ausfall kommt. Die hierdurch bedingte hohe Ausschußrate kann gesenkt werden, wenn der Versatz der einzelnen Lagen der Multilayer-Anordnung gegeneinander bekannt ist, so daß die Positionen der zu bohrenden Löcher im Bohrprogramm so bestimmt werden können, daß der Kontakt zwischen den Auskleidungen der Löcher und den einzelnen Leiterbahnen möglichst gleichmäßig ist.

Um dieses Ziel zu erreichen, wurden bisher geeignete Meßmarken in den Randbereich der Innenlage der Multilayer-Anordnung eingebracht und der im Strahlenkegel einer punktförmigen Röntgenstrahlungsquelle entstehende Schatten vermessen. Durch Auswertung des erhaltenen Bildes wurden dann Versatz und Verzug jeder einzelnen Innenlage ermittelt und hieraus die gegebenenfalls erforderlichen Änderungen des Bohrprogramms vorgenommen. Die Kombination einer derartigen Röntgenbildauswertung mit einer Leiterplattenbohrmaschine ist jedoch technisch sehr aufwendig und damit auch mit relativ hohen Kosten verbunden.

Es ist daher die Aufgabe der vorliegenden Erfindung, ein Verfahren zur Messung des gegenseitigen Versatzes der mit Leiterbahnen versehenen Lagen einer Multilayer-Anordnung, um jeweils die geeignete Position für die nachfolgend herzustellenden, zur elektrischen Verbindung der Leiterbahnebenen dienenden Bohrungen durch die Multilayer-Anordnung festzulegen, anzugeben, das auf einfache Weise und mit geringem Geräteaufwand eine genaue Bestimmung des Versatzes ermöglicht.

Diese Aufgabe wird erfindungsgemäß gelöst durch die im kennzeichnenden Teil des Anspruchs 1 angegebenen Merkmale. Vorteilhafte Weiterbildungen des erfindungsgemäßen Verfahrens sowie Ausbildungen einer bevorzugten Vorrichtung zur Durchführung dieses Verfahrens ergeben sich aus den Unteransprüchen.

Die Erfindung zeichnet sich dadurch aus, daß jede Lage in definierter Position ein optisch erkennbares Muster trägt, wobei sich diese Muster in der Multilayer-Anordnung zumindest teilweise überdecken, daß in der Multilayer-Anordnung mindestens eine Inspektionsbohrung hergestellt wird, derart, daß diese die Muster jeder Lage schneidet, und daß die Schnittkanten jedes Musters in der Inspektionsbohrung optisch erfaßt werden. Da jedes Muster eine definierte Position gegenüber den Leiterbahnen der zugehörigen Lage aufweist, kann aus dem gegenseitigen Versatz der Muster der verschiedenen Lagen auf den gegenseitigen Versatz der Leiterbahnen dieser Lagen geschlossen werden. Da weiterhin die zur Messung verwendeten Schnittkanten der einzelnen Muster erst nach dem Verpressen der einzelnen Lagen zu einer Multilayer-Anordnung durch einen gemeinsamen Bearbeitungsvorgang hergestellt werden, ist eine durch diesen Vorgang bedingte Fehlerquelle praktisch ausgeschlossen.

Vorzugsweise besteht das Muster jeder Lage aus einem Kreuz aus zwei senkrecht zueinander stehenden Streifenmustern, wobei das Streifenmuster aus mindestens drei parallelen Strichen mit beispielsweise 0,01 Zoll Breite und 0,01 Zoll Isolationsabstand besteht, und wobei die Kreuze bei versatzfreier Anordnung jeder Lage einander vollständig überdecken und die Mittelachse der einen größeren Durchmesser als die Breite der Streifen aufweisenden Inspektionsbohrung mit den Kreuzmittelpunkten zusammenfällt. Hierdurch erhält man in der Inspektionsbohrung für jede Lage vier mal drei Schnittmarken, die jeweils um 90° gegeneinander versetzt sind. Die jeweils gegenüberliegenden dreier Schnittmarkenmuster dienen zur Bestimmung des Versatzes der Lagen in der zu ihrer Verbindungslinie senkrechten Richtung. Das Dreiermarkenmuster liefert redundante Informationen für die automatische Bildauswertung, falls wegen Verschmutzung oder Ätzfehlern ein Teil der Schnittmarkenmuster nicht mehr zu erkennen ist.

Jede Lage weist zweckmäßig mindestens zwei kreuzförmige Muster auf, und es werden eine entsprechende Anzahl von Inspektionsbohrungen vorgenommen. Auf diese Weise läßt sich nicht nur ein gegenseitiger Versatz der Lagen in den durch die kreuzförmigen Muster vorgegebenen Richtungen ermitteln, sondern auch ein etwaiger Versatz durch gegenseitige Verdrehung.

Es ist vorteilhaft, die Muster aus dem gleichen Material wie die und gleichzeitig mit den Leiterbahnen herzustellen, wobei diese elektrisch gegeneinander isoliert sind. Hierdurch ist für die Bildung der Muster kein zusätzlicher Arbeitsgang erforderlich.

Die Erfindung wird im folgenden anhand eines in den Figuren dargestellten Ausführungsbeispiels näher erläutert. Es zeigen:

Fig. 1    eine Leiterplattenbohrmaschine mit einer Meßeinrichtung für den gegenseitigen Versatz der Lagen einer Multilayer-Anordnung in perspektivischer Darstellung,

Fig. 2 die Draufsicht auf eine Inspektionsbohrung, und

Fig. 3 das optische System zur Erfassung der Schnittkanten der Muster in der Inspektionsbohrung in Schnittdarstellung.

Auf einer Grundplatte 1 ist ein Bohrtisch 2 in Richtung des Pfeiles 3 (Y-Richtung) verschiebbar gelagert. Auf dem Bohrtisch 2 ist eine Multilayer-Platine 4 aufgespannt, um an dieser Bohrarbeiten vornehmen zu können.

Eine den Bohrtische 2 überspannende, feststehende Brücke 5 stützt sich auf der Grundplatte 1 ab. Der zum Bohrtisch 2 parallele Teil der Brücke 5 trägt eine auf diesem in Richtung des Pfeiles 6 (X-Richtung) verschiebbare manschettenförmige Halterung 7, an der ein Ansatz 8 befestigt ist, in dem eine Bohrspindel 9 in Richtung des Pfeiles 10 (Z-Richtung) bewegbar gelagert ist. Die Multilayer-Platine 4 und ein in der Bohrspindel 9 eingespannter Bohrer sind somit in X-, Y- und Z-Richtung gegeneinander bewegbar, so daß Bohrarbeiten an jeder beliebigen Stelle und bis zu jeder beliebigen Tiefe an der Multilayer-Platine 4 vorgenommen werden können. Die Grundplatte 1 trägt weiterhin eine Werkzeugwechselstation 11, die verschiedene Werkzeuge für die Aufnahme in der Bohrspindel 9 bereithält.

Die insoweit bekannte Leiterplattenbohrmaschine trägt an der Halterung 7 über einen gegenüber dieser in Z-Richtung verschiebbaren Schlitten 12 noch ein optisches System 13, das neben der Bohrspindel 9 montiert ist. Eine nicht gezeigte, beispielsweise pneumatisch betätigbare Verriegelung koppelt den Schlitten 12 mit dem Antrieb der Bohrspindel 9 in Z-Richtung, so daß das optische System 13 nach der Verriegelung in Z-Richtung mit einer Genauigkeit von +/- 1/100 mm über einen Gesamtweg von 20 mm positioniert werden kann.

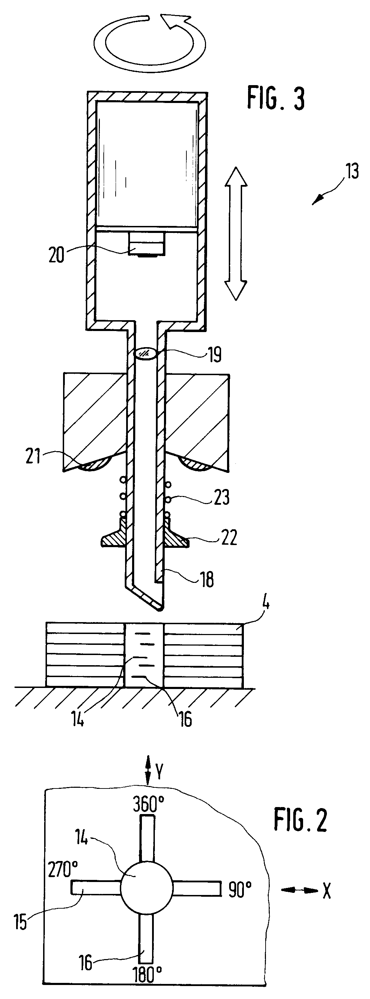

Das System 13 dient zur optischen Erfassung der Schnittkanten von Mustern in mindestens einer Inspektionsbohrung 14, die nach dem Verpressen in der auf dem Bohrtisch 2 aufgespannten Multilayer-Platine 4 hergestellt wurde. Fig. 2 zeigt die Draufsicht auf ein Muster einer Lage und die zugehörige Inspektionsbohrung 14. Das Muster besteht aus zwei sich senkrecht kreuzenden Streifenmustern 15, 16 mit je mindestens drei Strichen mit beispielsweise einer Länge von 8 mm und einer Breite der Streifenmuster von 0,05 Zoll. Das Muster wird in den zur Ausbildung der Leiterbahnen der Lage verwendeten Film kopiert und in gleicher Weise wie die Leiterbahnen hergestellt. Die Koordinaten der Mittelpunkte der kreuzförmigen Muster sind im Bohrprogramm registriert. Die Muster der einzelnen Lagen in der Multilayer-Platine sind, wenn kein Versatz zwischen diesen Lagen besteht, exakt übereinander angeordnet.

Die verpreßte Multilayer-Platine 4 wird nun auf den Bohrtisch 2 aufgespannt und es werden die Inspektionsbohrungen 14 durch die Muster hindurchgebohrt, derart, daß die Mittellinie dieser Bohrungen durch die im Bohrprogramm gespeicherten Mittelpunkte der kreuzförmigen Muster geht. Der Durchmesser der Inspektionsbohrungen 14 liegt zwischen der Breite der Länge der Streifen 15 und 16; er beträgt zum Beispiel 6 mm. Auf diese Weise erhält man je Muster, d.h. je Lage in einer Inspektionsbohrung 14 vier dünne Schnittkantenmuster als optische sichtbare Marken, und zwar je drei Marken in jedem Quadranten. Wenn kein Versatz zwischen den einzelnen Lagen besteht, liegen die Schnittkanten der einzelnen Muster genau gegeneinander ausgerichtet übereinander. Eine Abweichung von dieser Ausrichtung ergibt sich durch einen entsprechenden Versatz der zugeordneten Lage. Die Bezugslinie für die Abweichung liegt in der in Streifenlängsrichtung durch die gespeicherten Mittelpunkte der Muster verlaufenden Ebene.

An den Schnittkanten eines Streifens ergibt sich der Versatz in der zur Streifenlängsrichtung senkrechten Richtung, zum Beispiel aus den Schnittkanten des Streifens 15 der Versatz in Y-Richtung und aus den Schnittkanten des Streifens 16 der Versatz in X-Richtung.

Beim Bohren der Inspektionsbohrungen 14 ergibt sich das folgende Problem. Die Schnittkante des das Muster bildenden Kupferbandes mit einer Fläche von beispielsweise 200 $\mu$m x 10 $\mu$m ist jeweils nur an dem Ende scharf ausgebildet, auf das der Bohrer zuerst trifft (vorderes Ende), während am hinteren Ende ein unregelmäßiger Grat mit einer Länge bis zu 50 $\mu$m gezogen wird. Das hintere Ende ist daher für eine Bestimmung des Versatzes unbrauchbar. Auch eine Auswertung in der Weise, daß nur das vordere Ende der Schnittkante ermittelt und hierzu die halbe Breite der Schnittkante addiert wird, ist nicht ausreichend, da hierbei etwaige Abbildungsfehler der Leiterbahnbreiten (Belichtungsfehler, Unterätzungen und dergleichen) als Fehler in das Meßergebnis eingehen würden. Das optische System 13 ist daher drehbar konzipiert, so daß für die Vermessung des Versatzes in X-Richtung jeweils die vorderen Enden der Schnittkanten des Streifens 16 bei 180° und 360° und in Y-Richtung jeweils die vorderen Enden der Schnittkanten des Streifens 15 bei 90° und 270° ausgewertet werden. Erst die beiden vorderen Enden der einander gegenüberliegenden Schnittkanten ergeben die genaue Information über den Versatz des Musters in X- bzw. Y-Richtung, wobei mittels Bildauswertung die exakte Lage des Musters errechnet werden kann.

Es sind mindestens zwei Inspektionsbohrungen 14 vorgesehen, so daß durch einen Vergleich des dort jeweils gemessenen Versatzes auch festgestellt werden kann, inwieweit die einzelnen Lagen gegeneinander verdreht sind.

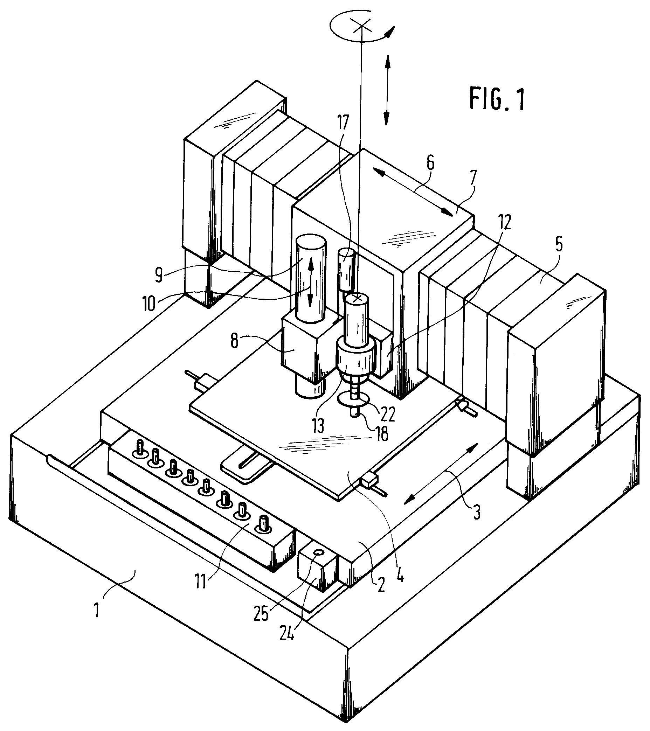

Das optische System 13 ist in Fig. 3 näher dargestellt. Dieses ist über den Schlitten 12 in Z-Richtung verschiebbar sowie auch drehbar gelagert, wobei es in vier um jeweils 90° gegeneinander versetzten Stellungen positioniert werden kann, in denen je eine Reihe übereinanderliegender Schnittkanten abgetastet werden kann. Zur Drehung und entsprechenden Positionierung ist ein Schrittmotor 17 (Fig. 1) vorgesehen.

Das optische System 13 besteht im wesentlichen aus einem Miniaturperiskop 18, einem Präzisionsobjektiv 19, einer hochauflösenden CCD-Kamera 20 und bei transparentem Material aus einer Glasfaserbeleuchtung 21 mit Blende 22 bzw. bei nicht transparentem Material aus einer Auflichtbeleuchtung mit Strahlenteiler und Lichtquelle. Die Blende 22 ist verschiebbar auf dem Periskop 18 angeordnet und wird durch eine Feder 23 zu dessen Spitze hin vorgespannt, so daß sie, wenn das Periskop 18 in eine Inspektionsbohrung 14 der Multilayer-Platine 4 eingeführt ist, den Spalt zwischen der Innenwandung der Inspektionsbohrung 14 und dem Periskop 18, dessen Durchmesser beispielsweise 4 mm beträgt, abdeckt, um das Eindringen von Streulicht in den Spalt zu verhindern. Für den Fall, daß das Trägermaterial durchsichtig ist und die Eintrittsfläche Lichtes frei von Leiterplattenmaterial, tritt das von der Ringleuchte 21 ausgesandte Licht um die Blende 22 herum in die Multilayer-Platine 4 hinein und die Inspektionsbohrung wird ausgeleuchtet.

Am Periskop 18 ist weiterhin eine Luftdüse angebracht, die nach jedem Meßvorgang die seitliche Lichteintrittsfläche freibläst und damit unerwünschte Staubablagerungen verhindert.

Das Trägermaterial der Lagen der Multilayer-Platine 4 ist durchlässig und der Umkreis der Inspektionsbohrungen 14 ist frei von Leitermaterial, so daß von der Ringleuchte 21 ausgesandtes Licht um die Blende 22 herum in die Multilayer-Platine 4 eintritt und die Inspektionsbohrungen 14 ausleuchtet. Die Schnittkanten der Streifen 15, 16 sind deutlich sichtbar und werden vom Periskop 18 abgetastet, das zu diesem Zweck in die Inspektionsbohrung 14 abgesenkt wurde und diese in jeder der vier Drehstellungen in Z-Richtung abfährt. Somit wird die Lage jeder einzelnen Schnittkante in einer Inspektionsbohrung optisch erfaßt und kann für die Ermittlung des Versatzes der zugehörigen Lage ausgewertet werden.

Auf der Fangplatte 1 ist in Höhe der Werkzeugwechselstation 11 ein Eichblock 24 (Fig. 1) befestigt, der in einer Eichbohrung 25 Eichmarken enthält, die zur Justierung der Periskops 18 dienen.

Hierbei können Fehler der folgenden Betriebsgrößen festgestellt und für eine nachfolgende Kompensation der Meßergebnisse gespeichert werden: Abbildungsmaßstab des optischen Systems, Nullpunktversatz der Maschine und Winkelgenauigkeit der Drehung des Periskops.

Wenn das Trägermaterial der Lagen der Multilayer-Platine lichtundurchlässig ist, muß die Inspektionsbohrung mittels einer geeigneten Auflichtbeleuchtung zur optischen Erfassung der Schnittkanten des Musters ausgeleuchtet werden.

**Patentansprüche**

1. Verfahren zur Messung des gegenseitigen Versatzes der mit Leiterbahnen versehenen Lagen einer Multilayer-Anordnung, um jeweils eine geeignete Position für die nachfolgend herzustellenden, zur elektrischen Verbindung der Leiterbahnebenen dienenden Bohrungen durch die Multilayer-Anordnung festzulegen,
**dadurch gekennzeichnet,**
daß jede Lage in definierter Position ein optisch erkennbares Muster (15,16) trägt, wobei sich diese Muster in der Multilayer-Anordnung (4) zumindest teilweise überdecken, daß in der Multilayer-Anordnung (4) mindestens eine Inspektionsbohrung (14) hergestellt wird, derart, daß diese die Muster (15,16) jeder Lage schneidet und daß die Schnittkanten jedes Musters (15,16) in der Inspektionsbohrung (14) optisch erfaßt werden.

2. Verfahren nach Anspruch 1, dadurch gekennzeichnet, daß die Muster jeder Lage aus einem Kreuz aus zwei senkrecht zueinanderliegenden Streifenmustern aus mindestens jeweils drei parallelen Strichen besteht, mit vorzugsweise einer Dicke von 0,01 Zoll und Abständen untereinander von 0,01 Zoll, wobei die Kreuze bei versatzfreier Anordnung jeder Lage einander vollständig überdecken und die Mittelachse der die einen größeren Durchmesser als die Breite der Streifen aufweisenden Inspektionsbohrung mit den Kreuzmittelpunkten zusammenfällt.

3. Verfahren nach Anspruch 2, dadurch gekennzeichnet, daß jede Lage mindestens zwei kreuzförmige Muster (15,16) aufweist und eine entsprechende Anzahl von Inspektionsbohrungen (14) vorgenommen werden.

4. Verfahren nach einem der Ansprüche 1 bis 3, dadurch gekennzeichnet, daß die Muster (15,16) aus dem gleichen Material wie die und gleichzeitig mit den Leiterbahnen hergestellt werden und elektrisch von diesen isoliert sind.

5. Verfahren nach einem der Ansprüche 2 bis 4, dadurch gekennzeichnet, daß aus den vier dreier Schnittmarkenmustern jedes Kreuzes (15,16) der Versatz der zugeordneten Lage in zwei zueinander senkrechten Richtungen ermittelt wird.

6. Verfahren nach einem der Ansprüche 1 bis 5, dadurch gekennzeichnet, daß zur Ermittlung des Versatzes nur das bei der Herstellung der Inspektionsbohrung (14) in Drehrichtung des Bohrers hintere Ende jeder Schnittkante herangezogen wird.

7. Verfahren nach einem der Ansprüche 1 bis 6, dadurch gekennzeichnet, daß zur optischen Abtastung der Schnittkanten innerhalb der Inspektionsbohrung (14) ein in diese einführbares Miniaturperiskop (18) verwendet wird.

8. Verfahren nach Anspruch 7, dadurch gekennzeichnet, daß das Miniaturperiskop (18) in der Inspektionsbohrung (14) um eine zur Ebene der Lagen senkrechte Achse gedreht und in vier jeweils zueinander senkrechten Stellungen positioniert wird.

9. Verfahren nach Anspruch 7 oder 8, dadurch gekennzeichnet, daß das vom Miniaturperiskop (18) aufgenommene Bild über ein Objektiv (19) zu einer CCD-Kamera (20) geleitet wird.

10. Verfahren nach einem der Ansprüche 1 bis 9, dadurch gekennzeichnet, daß das Multilayer-Trägermaterial durchsichtig ist und die Beleuchtung der Innenwandung der Inspektionsbohrung (14) von außen durch das Trägermaterial hindurch erfolgt.

11. Verfahren nach einem der Ansprüche 1 bis 9, dadurch gekennzeichnet, daß das Multilayer-Trägermaterial undurchsichtig ist und durch Einsatz eines Strahlenteilers in den Strahlengang eine parallele Lichtquelle in Richtung der Innenwandung der Inspektionsbohrung ausgerichtet wird und nach Reflexion auf den metallisch glänzenden Kupfermarken diese mit dem Objektiv (19) auf der CCD-Kamera abgebildet werden.

12. Verfahren nach einem der Ansprüche 7 bis 11, dadurch gekennzeichnet, daß das Miniaturperiskop (18) mittels in einer feststehenden Eichbohrung (25) ausgebildeten Eichmarken justiert wird.

13. Vorrichtung zur Durchführung des Verfahrens nach einem der Ansprüche 1 bis 12, dadurch gekennzeichnet, daß das optische System (13) zur Erfassung der Schnittkanten der Muster (15,16) in der Inspektionsbohrung (14) aus einer Beleuchtungsvorrichtung (21,22), einem Miniaturperiskop (18), einem Präzisionsobjektiv (19) und einer hochauflösenden CCD-Kamera (20) besteht.

14. Vorrichtung nach Anspruch 13, dadurch gekennzeichnet, daß das optische System (13) zur Bewegung senkrecht zur Ebene der Multilayer-Anordnung (4) mit der Bohrspindel (9) zur Durchführung von Bohrungen in der Multilayer-Anordnung (4) gekoppelt ist.

15. Vorrichtung nach Anspruch 12 oder 13, dadurch gekennzeichnet, daß das optische System (13) drehbar gelagert ist.

16. Vorrichtung nach einem der Ansprüche 13 bis 15, dadurch gekennzeichnet, daß die Beleuchtungsvorrichtung eine das Miniaturperiskop (18) umschließende Ringleuchte (21) aufweist.

17. Vorrichtung nach einem der Ansprüche 13 bis 16, dadurch gekennzeichnet, daß die Beleuchtungsvorrichtung eine das Miniaturperiskop (18) umschließende, verschiebbare und in Richtung auf die Multilayer-Anordnung (4) federnd vorgespannte Blende (22) zum Verschließen des Spalts zwischen der Multilayer-Anordnung (4) und dem in diese eingeführten Miniaturperiskop (18) aufweist.

18. Vorrichtung nach einem der Ansprüche 13 bis 17, dadurch gekennzeichnet, daß das Miniaturperiskop (18) mit einer Luftdüse versehen ist für das Wegblasen von Schmutzteilchen von der Lichteintrittsfläche des Miniaturperiskops (18).

19. Vorrichtung nach einem der Ansprüche 13 bis 18, dadurch gekennzeichnet, daß die Eichbohrung (25) für die Justierung des Miniaturperiskops (18) in einem auf der Grundplatte (1) befestigten Block (24) vorgesehen ist.

FIG.1

FIG. 3

13

20

19

21

23

22

18

4

14

16

Y

360°

14

270°

15

90°

X

16

180°

FIG. 2